Europäisches Patentamt

European Patent Office

Office européen des brevets

(19)

(11) Veröffentlichungsnummer: **0 360 035**
**A2**

(12) **EUROPÄISCHE PATENTANMELDUNG**

(21) Anmeldenummer: **89115839.6**

(22) Anmeldetag: **28.08.89**

(51) Int. Cl.5. **H01J 37/063 , H01J 37/30**

(30) Priorität: **20.09.88 DE 3831940**

(43) Veröffentlichungstag der Anmeldung:
**28.03.90 Patentblatt 90/13**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **Rose, Harald, Prof. Dr.**
**Prinz-Christians-Weg 5 a**
**D-6100 Darmstadt(DE)**
Erfinder: **Schönecker, Gerhard, Dipl.-Phys.**
**Hans-Thoma-Strasse 17**
**D-6090 Rüsselsheim(DE)**

(54) **Elektronenstrahlerzeuger.**

(57) Der Elektronenstrahlerzeuger besteht aus einer linienförmigen Kathode (K), insbesondere einem LaB6-Schneidenemitter mit abgeflachter Spitze, einer in der Ebene der Kathodenspitze angeordneten Schlitzblende (W) und einer Doppelanode, deren Elektroden (A1, A2) ebenfalls als Schlitzblenden ausgebildet sind. Die Potentiale ($V_W$, $V_{A1}$, $V_{A2}$) der Schlitzblenden (W, A1, A2) und deren Abstände (z) zur Kathode (K) werden jeweils so vorgegeben, daß eine stigmatische virtuelle Elektronenquelle im Unendlichen liegt.

FIG 6

EP 0 360 035 A2

## Elektronenstrahlerzeuger

Die Erfindung bezieht sich auf einen Elektronenstrahlerzeuger nach dem Oberbegriff des Patentanspruchs 1.

Aus der US-A-4 724 328 ist ein Lithographiegerät (Elekronenstrahlschreiber) bekannt, dessen elektronenoptische Säule eine Steuerblende zur Erzeugung einer Vielzahl individuell ablenk- bzw. austastbarer Elektronensonden aufweist. Diese in der EP-191 439 A1 näher beschriebene Blende besteht im wesentlichen aus einer Siliziumscheibe, deren mittlerer Teil als freitragende Membran ausgebildet und mit einer linienförmigen Anordnung quadratischer Ausnehmungen versehen ist. Als Ablenkeinheit dient ein im Bereich der Ausnehmungen angeordnetes Elektrodensystem. Um den verfügbaren Quellenstrom optimal auszunutzen, wird die Steuerblende mit einem bandförmigen Elektronenstrahl ausgeleuchtet. Diesen erzeugt man mit Hilfe einer aus einer Zylinderlinse und einer Kondensorlinse bestehenden Optik, die im Strahlengang zwischen dem einen LaB6-Schneidenemitter aufweisenden Strahlerzeuger und der Blende angeordnet ist.

Der Erfindung liegt die Aufgabe zugrunde, einen Strahlerzeuger der eingangs genannten Art anzugeben, mit dem ein bandförmiges Objekt, insbesondere eine Blende mit einer linienförmigen Anordnung von Ausnehmungen, gleichmäßig ausgeleuchtet werden kann. Diese Aufgabe wird erfindungsgemäß durch einen Elektronenstrahlerzeuger nach Patentanspruch 1 gelöst.

Der mit der Erfindung erzielbare Vorteil besteht insbesondere darin, daß der Anteil des Strahlstroms, der in der Objektebene Gebiete außerhalb der auszuleuchtenden Fläche durchsetzt, sehr gering ist. Außerdem kann die stochastische Coulomb-Wechselwirkung (Boersch-Effekt) im Strahlerzeuger sehr klein gehalten werden.

Die Ansprüche 2 bis 6 betreffen bevorzugte Ausgestaltungen und Weiterbildungen des erfindungsgemäßen Elektronenstrahlerzeugers.

Die Erfindung wird im folgenden anhand der Zeichnungen näher erläutert. Hierbei zeigt:

Figur 1 ein Ausführungsbeispiel eines erfindungsgemäßen Elektronenstrahlerzeugers

Figur 2 die Elektronenoptik zur Ausleuchtung der Steuerblende des bekannten Lithographiegerätes

Figur 3 die Kathode des Elektronenstrahlerzeugers

Figur 4 die Kathode und die erste Schlitzblende in Draufsicht

Figur 5 die Strahlcharakteristik in der Ebene der Steuerblende

Figur 6 die Elektronenbahnen innerhalb des Strahlerzeugers

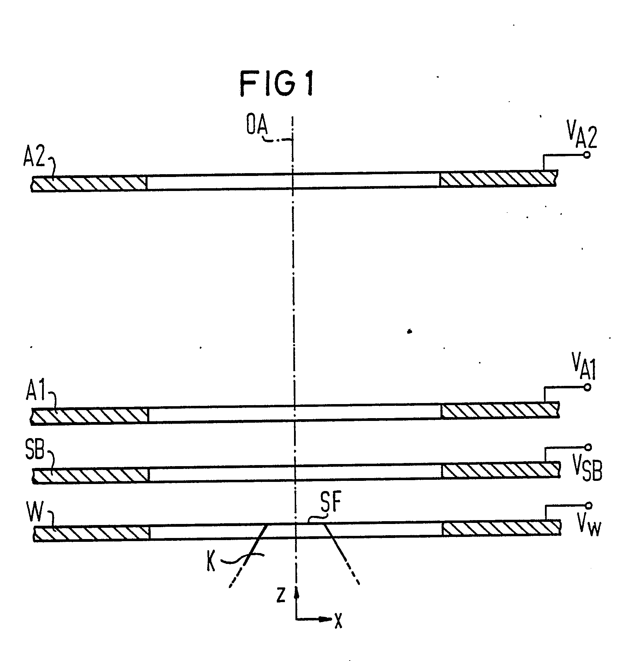

Der in Figur 1 schematisch dargestellte Elektronenstrahlerzeuger kann beispielsweise in dem aus der US-A-4 724 328 bekannten Lithographiegerät zu gleichförmigen Ausleuchtungen der in der Steuerblende vorhandenen linienförmigen Anordnung quadratischer oder rechteckförmiger Ausnehmungen verwendet werden. Er besteht im wesentlichen aus einer linienförmigen Kathode K, insbesondere einem LaB6-Schneidenemitter mit abgeflachter Spitze, einer in der Ebene der Kathodenspitze angeordneten Schlitzblende W und einer Doppelanode, deren Elektroden A1 bzw. A2 ebenfalls als Schlitzblenden ausgebildet sind. Während die Elektroden A1 und A2 jeweils auf einem positiven Potential $V_{A1}$ bzw. $V_{A2}$ liegen, wird die der Feldformung dienende Schlitzblende W negativ geladen ($V_W$), um eine starke Aufweitung des von der Kathode K ausgehenden Elektronenstrahls zu vermeiden. Diese Potentialbelegung hat außerdem zur Folge, daß sich die Elektronenemmission im wesentlichen auf die senkrecht zur Strahlachse OA orientierte Stirnfläche SF der Kathode K beschränkt. Um auch die in den Randbereichen der Kathodenstirnfläche SF austretenden Elektronen abzufangen ist es von Vorteil, eine weitere Schlitzblende SB zwischen den Elektroden W und A1 anzuordnen und mit einem Potential $V_{SB}$

$$V_W < V_{SB} < V_{A1}$$

zu belegen. Wird die Schlitzblende SB in der Mitte zwischen den Elektroden W und A1 abgeordnet, sollte das Potential $V_{SB}$ den Wert

$$V_{SB} = 1/2 (V_{A1} - V_W)$$

annehmen.

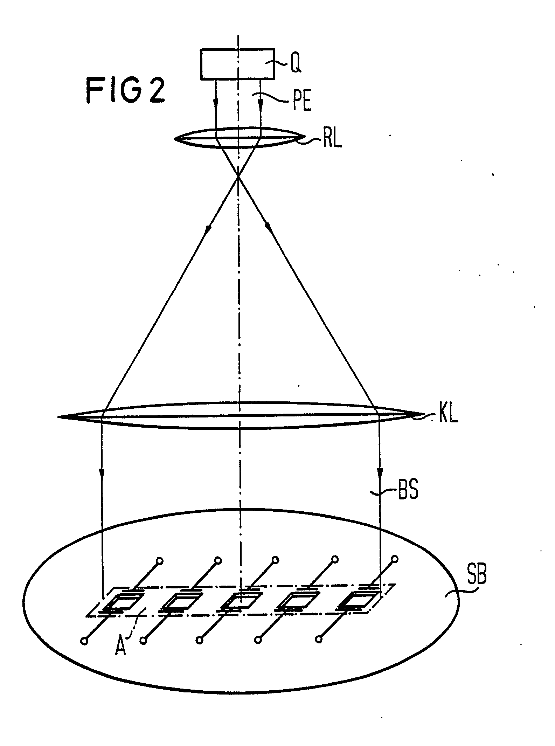

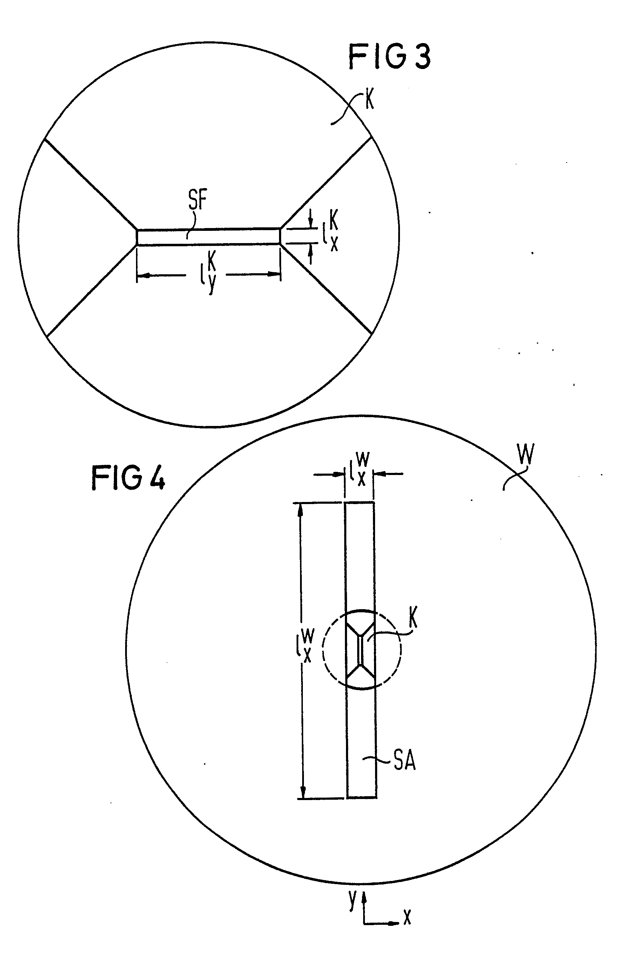

Um ein langgezogenes Rechteck der Fläche A = 20 x 0,01 mm² auf der Steuerblende SB gleichmäßig mit einem entsprechend geformten Elektronenstrahl (Bandstrahl) BS auszuleuchten, ist es notwendig, die Abmessungen der Kathode K den Abmessungen der linienförmigen Lochstruktur anzupassen (siehe Fig. 2 und 3). So sollte die Stirnfläche SF der Kathode K eine Länge $l_y^K \approx 1$ mm und eine Breite $l_x^K < 10$ $\mu$m, insbesondere $l_x^K \approx 5$ $\mu$m aufweisen, wenn die dem Strahlerzeuger Q nachgeordnete Elektronenoptik RLKL etwa 20fach vergrößert abbildet. Hierbei wird vorausgesetzt, daß der Querschnitt des den Strahlerzeuger Q verlassenden Elektronenstrahls PE annähernd dem Querschnitt der emittierenden Kathodenfläche SF entspricht. Ist dies nicht der Fall, muß man die Vergrößerung der beispielsweise aus einer Rundlinse RL und einer Kondensorlinse KL bestehenden Elektronenoptik entsprechend anpassen.

Das innerhalb des Strahlerzeugers aufgebaute Beschleunigungsfeld soll zylindersymmetrisch sein. Eine solche Feldverteilung ist insbesondere dann in guter Nährung gewährleistet, wenn das Längen-Breitenverhältnis der schlitzförmigen Blendenöffnungen jeweils etwa dem Längen- Breitenverhältnis der Stirnfläche SF der Kathode K entspricht. Für die Blenden des Strahlerzeugers sollte deshalb die Beziehung

$$l_x^K \cdot l_x^K \approx l_x^i \cdot l_y^i$$

$$i = W, SB, A1, A2$$

erfüllt sein, wobei $l_x^i$ und $l_y^i$ die jeweils in x-Richtung gemessene Breite bzw. die in y-Richtung gemessene Länge der schlitzförmigen Ausnehmungen SA der Elektroden W, SB, A1 und A2 bezeichnen. In den Figuren 3 und 4, die die an der Spitze abgeflachte Kathode K bzw. die Kathode K und die Schlitzblende W jeweils in Draufsicht zeigen, wurde aus Gründen der Übersichtlichkeit nur ein Längen-Breitenverhältnis von

$$l_x^K \cdot l_y^K = l_x^W \cdot l_y^W = 1/10$$

gewählt.

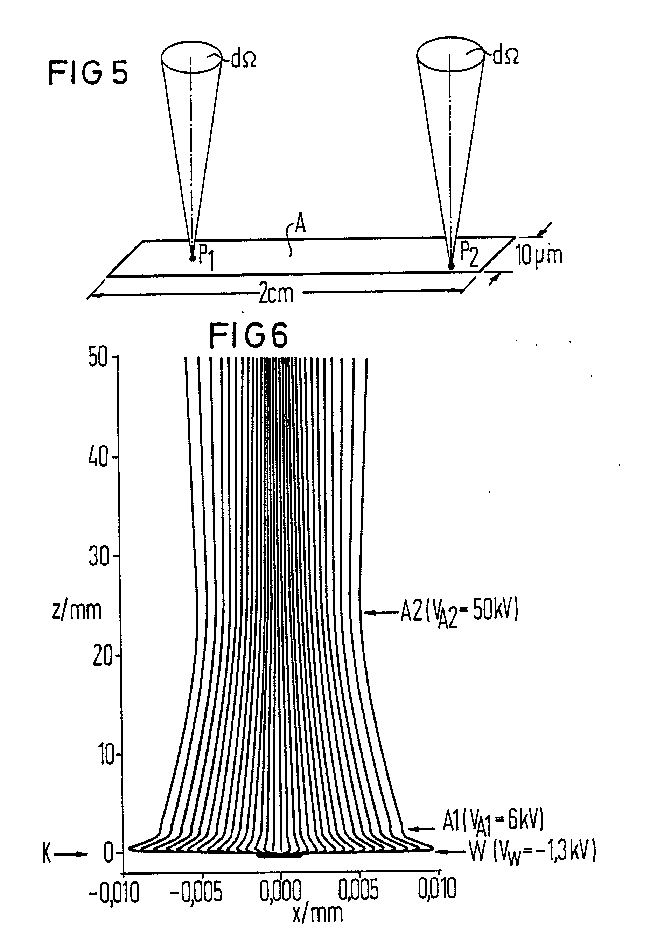

In dem bekannten Lithographiegerät soll ein langgezogenes Rechteck der Fläche A = 20 x 0,01 mm² mit einem bandförmigen Elektronenstrahl der Energie $E_{PE}$ = 50 keV gleichmäßig ausgeleuchtet werden (siehe Fig. 5). Die Elektronenbündel durch verschiedene Punkte Pi (i = 1,2...) dieser Fläche A müssen hierbei parallel zueinander sein (Köhler-Beleuchtung) und sollen jeweils ein rundes Raumwinkelelement dΩ gleichmäßig ausfüllen. Um diese Forderungen zu erfüllen, muß zuerst sichergestellt sein, daß die virtuelle Elektronenquelle im x-z-Schnitt und im y-z-Schnitt zusammenfällt. Da diese aufgrund der Schlitzgeometrie ($l_y^i \gg l_x^i$) im y-z-Schnitt im Unendlichen liegt, wird das Beschleunigungsfeld im Strahlerzeuger derart eingestellt, daß die Elektronenbahnen auch im x-z-Schnitt parallel zur Strahlachse OA verlaufen. Auf diese Weise erzeugt man eine stigmatische virtuelle Elektronenquelle im Unendlichen. Im einzelnen ist hierbei wie folgt vorzugehen:

a) Das Potential $V_{A1}$ der Anode A1 und deren Abstand zur Kathode K sind so einzustellen, daß der gewünschte Strahlstrom aus der Kathode K gezogen wird.

b) Die Lage der auf dem vorgegebenen Potential $V_{A2}$ von beispielsweise $V_{A2}$ = 50 kV liegenden Anode A2 (Kathodenpotential $V_K$ = 0V, $E_{PE}$ = 50 keV; siehe oben) ist so einzustellen, daß ein annähernd paralleler Elektronenstrahl entsteht.

c) Die Potentiale $V_W$ und $V_{A1}$ der negativ geladenen Schlitzblende W und der Anode A1 sowie deren Abstand zueinander sind jeweils so vorzugeben, daß der Strahlquerschnitt annähernd dem Querschnitt der emittierenden Kathodenfläche SF entspricht. Hierdurch wird eine fast runde Strahldivergenz erreicht.

Bei den unter Punkt c) angegebenen Schritten ist zu beachten, daß stets der gewünschte Strahlstrom erreicht wird.

In Figur 5 sind die Ergebnisse einer Modellrechnung für die Elektronenbahnen in einem erfindungsgemäßen Strahlerzeuger dargestellt. Der Rechnung liegen die Annahmen zugrunde, daß die Elektronen bei z = 0 mm und x = 0 ± ... 0,1... ±1,5 µm ... mit der Geschwindigkeit $V_{PE}$ = 0 von der in y-Richtung unendlich ausgedehnten Kathode K starten. Die Position der Schlitzblenden W, A1 und A2 auf der Strahlachse sind jeweils durch Pfeile gekennzeichnet. Außerdem sind die berechneten Potentiale $V_W$, $V_{A1}$ und $V_{A2}$ angegeben.

## Ansprüche

1. Elektronenstrahlerzeuger mit einer linienförmigen Kathode (K) und einer Anode (A2) zur Beschleunigung der aus der Kathode (K) austretenden Elektronen in der Richtung einer Strahlachse (OA), **dadurch gekennzeichnet,** daß die Anode (A2) als Schlitzblende ausgebildet ist, daß zwischen der Kathode (K) und der Anode (A2) eine erste Schlitzblende (W) angeordnet ist, daß zwischen der ersten Schlitzblende (W) und der Anode (A2) eine zweite Schlitzblende (A1) angeordnet ist und daß die Potentiale ($V_W$, $V_{A1}$, $V_{A2}$) der Schlitzblenden (W, A1, A2) und deren Abstände zur Kathode (K) jeweils so vorgegeben sind, daß eine stigmatische virtuelle Elektronenquelle im Unendlichen liegt.

2. Elektronenstrahlerzeuger nach Anspruch 1, **dadurch gekennzeichnet,** daß die Kathode (K) schneidenförmig ausgebildet und im Bereich der Spitze abgeflacht ist.

3. Elektronenstrahlerzeuger nach Anspruch 1 oder 2, **dadurch gekennzeichnet,** daß die negativ geladene erste Schlitzblende (W) in einer senkrecht zur Strahlachse (OA) orientierten Ebene im Bereich der Kathodenspitze angeordnet ist.

4. Elektronenstrahlerzeuger nach einen der Ansprüche 1 bis 3, **dadurch gekennzeichnet,** daß die zweite Schlitzblende (A1) auf einem positiven ersten Potential ($V_{A1}$) und die Anode (A2) auf einem positiven zweiten Potential ($V_{A2}$) liegt, wobei das erste Potential ($V_{A1}$) niedriger ist als das zweite Potential ($V_{A2}$).

5. Elektronenstrahlerzeuger nach einem der Ansprüche 1 bis 4, **dadurch gekennzeichnet,** daß zwischen der ersten (u) und der zweiten Schlitzblende (A1) eine dritte Schlitzblende (SB) angeordnet ist, und daß das Potential ($V_{SB}$) der dritten Schlitzblende (SB) höher als das Potential ($V_W$) der ersten Schlitzblende (W) und niedriger als das Potential ($V_{A1}$) der zweiten Schlitzblende (A1) ist.

6. Elektronenstrahlerzeuger nach Anspruch 5, **dadurch gekennzeichnet,** daß die dritte Schlitzblende (SB) in der Mitte zwischen der ersten (W) und der zweiten Schlitzblende (A1) angeordnet ist.

# FIG 1

FIG 2

FIG 3

FIG 4

FIG 5

FIG 6